# EUROPEAN PATENT APPLICATION

(11) **EP 2 177 644 A1**
(43) Date of publication of application: **21.04.2010**
(21) Application number: 08166538.2
(22) Date of filing: 14.10.2008
(51) Int. Cl.: C23C 14/04

(54) **Coating of masked substrates**

(71) Applicant: Applied Materials, Inc., Santa Clara, CA 95054 (US)
(72) Inventor: Dieguez-Campo, Jose Manuel, 63457 Hanau (DE); White, John M., Hayward, CA 94541 (US); Landgraf, Heike, 63486, Bruchköbel (DE)
(74) Representative: Lang, Christian

(57) **Abstract**

The present invention refers to a coating installation and a corresponding method of coating a substrate (1), comprising the steps of:
providing a substrate (1) having at least one surface to be coated;
depositing a patterned mask layer (2) on the at least one surface of the substrate (1) by using a printing method, the patterned mask layer comprising one or more balls; depositing at least one layer (3,4) of coating material on the surface of the substrate (1) having the patterned mask layer (2) deposited thereon, depositing of the at least one layer being performed by at least one of the group comprising a vacuum deposition method, a sputtering method, an evaporation method, a plasma coating method, a CVD method, and a PVD method.

## Description

### BACKGROUND OF THE INVENTION

### TECHNICAL FIELD

The present invention refers to a method of coating a substrate as well as a coating installation used therefore.

### PRIOR ART

In various fields of prior art, for example semiconductor device manufacturing, solar panel manufacturing, organic light emitting diode (OLED) manufacturing, flat panel display (FPD) manufacturing and thin film transistor (TFT) manufacturing, it may be sometimes necessary to deposit one or more layers of material over the substrate, but only in selected areas. Depositing material in selected areas while not depositing in other areas of the same substrate can be complicated and expensive. Therefore, there is a need in the art for a method to deposit one or more layers over a substrate in preselected areas that is simple and affordable.

The use of shadow masks is expensive and the quality of the pattern decreases with an increasing number of coating processes due to deposition of coating material on the shadow mask. Therefore, the shadow mask has to be cleaned and exchanged intermittently. Photolithographic procedures, on the other hand, require a lot of equipment and a plurality of process steps and thus cause all in all high costs.

Consequently, efforts have been made to provide processes of manufacturing a structured or a patterned layer system which still have a high throughput, but are more cost efficient than conventional processes, while maintaining a high quality of the deposited structures.

### DISCLOSURE OF THE INVENTION

### OBJECT OF THE INVENTION

It is therefore an object of the present invention to provide a coating method as well as a coating installation for depositing patterned structures, especially patterned electrodes or patterned moisture and oxygen barrier layers for OLED devices on large area substrates, wherein the method and installation allow an efficient production of high-quality structures. Moreover, the method should be easily performed, while the installation should be easy to be produced.

### TECHNICAL SOLUTION

This object is achieved by a coating method having the features of claim 1 as well as a coating installation having the features of claim 16. Preferred embodiments are the subject matter of the dependent claims.

The inventors found that an easy, efficient and reliable way to produce patterned structures comprises depositing of a patterned mask layer by a printing method wherein the patterned mask layer comprises one or more balls. The mask material comprising one or more balls can be deposited very exactly and moreover the subsequent deposition of at least one layer or a stack of layers can be performed by sophisticated deposition methods, including vacuum deposition methods, sputtering methods, evaporation methods, plasma assisted coating methods, chemical vapour deposition (CVD) methods and / or physical vapour deposition (PVD) methods. It has been found that, although the patterned mask layer comprising the balls can be easily removed after the deposition of the subsequent layers, the subsequent deposited layers can be applied at a very high precision by the above-mentioned methods.

The method may be used for depositing metal materials like chromium, copper, titanium, tungsten, aluminium or the like and combinations thereof, transparent conductive oxides, like indium tin oxide (ITO), and / or semiconductor materials to form electrodes, electrode structures or current enhancement structures. Moreover, barrier layers formed by carbon layers, especially amorphous carbon layers, and / or silicon nitride layers can also be deposited.

The structures, which can be formed, may comprise line structures or grid structures.

The current enhancement structure may improve the electrical properties, for example of an OLED device, e.g. for current distribution.

Although electrode layers or structures, for example on a glass substrate, are preferred embodiments for carrying out the present invention, various other kinds of layer systems may be deposited according to the inventive method and / or by using the coating installation according to the present invention. Moreover, a variety of different substrates may be used, for example substrates which already comprise at least one layer or a stack of layers.

The present method may comprise additional steps of providing additional layers, for example steps of providing an optoelectronic device layer for the emission of light. The additional layers may or may not be produced according to the present invention.

The mask material comprising the balls may be deposited by different printing methods including inkjet printing, screen printing, porous printing, pad printing and / or combinations of such printing methods.

The masking material may comprise in addition to the balls ink or other fluids which may act as carrier substance for the printing deposition. The ink or the other carrier fluids may be evaporated after printing.

The masking material may comprise in addition to the balls an adhesive in order to improve adhesion of the masking material to the surface of the substrate to be coated. Accordingly, the adhesive may be identical to or part of the carrier fluid mentioned above.

Alternatively, an adhesive may be deposited prior to depositing of the masking material including the balls. The adhesive may also be deposited by printing methods. The printing methods may be the same as for the masking material.

Although the balls of the masking material are designated as the balls, these balls may have a shape different to a sphere. Moreover, the balls may have the shape of blocks or posts. The balls may have different dimensions depending on the structure size to be achieved by the inventive method.

The balls may be formed by nanoparticles or microparticles having diameters in the range of a few nm to hundreds of µm. Even balls having diameters of 0.5 mm to 1.5 mm may be used.

The masking material or patterned mask layer can be removed after the subsequent coating of the material to be structured by brushing, wiping, gas blasting, simple cleaning and combinations thereof.

A coating installation for carrying out the above-described method may comprise a printing tool for printing a patterned mask wherein the printing tool is adapted to print mask material comprising balls. In addition, the coating installation comprises a supply device for supplying mask material comprising balls. Moreover, the inventive coating installation comprises a process chamber, where the deposition of a coating layer can be performed according to at least one of the coating methods comprising vacuum deposition methods, sputtering methods, evaporation methods, plasma coating methods, chemical vapour deposition (CVD) methods and physical vapour deposition (PVD) methods. Accordingly, different material sources may be present in the coating installation, like carbon sources, silicon sources, nitrogen sources, silicon nitride sources, metal material sources, semiconductor material sources and TCO (transparent conductive oxide) material sources. In addition to the material sources mentioned above other material sources may be present depending on the kind of the patterned layer which has to be deposited.

In accordance with the method described above the coating installation may comprise printing tools like inkjet printer, screen printer or pad printing equipment as well as tools for removing the patterned mask material from the surface of the substrate or other coating equipment for subsequent coating of the substrate like equipment for depositing an organic electronic device onto the substrate.

### BRIEF DESCRIPTION OF THE DRAWINGS

Further advantages, characteristics and features become apparent by the following description of specific embodiments with respect to the attached drawings. The drawings show in a pure schematic way in
- Fig. 1a to 1d: a first embodiment of a method according to the present invention;
- Fig. 2a to 2c: a second embodiment of a method according to the present invention;
- Fig. 3: a detailed view of the patterned mask;
- Fig. 4: a view of an embodiment of an inventive coating installation; and in
- Fig. 5: a perspective view of an apparatus for inkjet printing according to one embodiment of the present invention.

### DESCRIPTION OF SPECIFIC EMBODIMENTS

The embodiments disclosed in this application refer to methods of depositing a patterned first electrode of an organic electronic device on a substrate. However, the invention is not restricted to these applications. Instead of this, the various layer systems including also water barrier layers or current enhancement line or grid structures of OLED devices may be deposited according to the present invention.

The substrate on which the electrode is deposited according to the embodiments shown may be the carrier of a layer system deposited thereon. It may or may not comprise e. g. one or a plurality of light emitting layers, functional and/or protective layers, barrier layers, etc. The light emitting layer or layer stack may be deposited on top of the patterned first electrode.

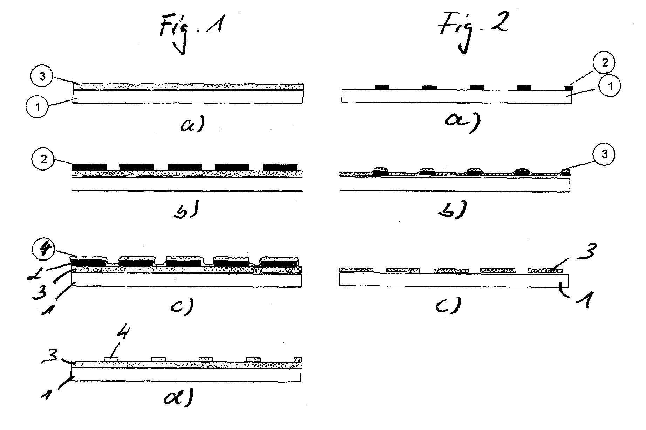

In the first embodiment of the invention the method comprises providing a large-area substrate 1 and depositing a first semiconductor, metal, or TCO (Transparent Conductive Oxide) layer 3 (or a combination of a plurality of layers including one or more of said materials) on a surface of the substrate 1 as illustrated in Fig. 1a. The layer 3 is deposited e.g. by an evaporation or sputtering method in a vacuum atmosphere.

In a second process step illustrated in Fig. 1b a patterned mask layer 2 is printed on top of the first layer 3. The mask layer 2 comprises balls, which may be deposited in an inkjet printing method. The balls may be deposited together with an adhesive or onto a layer of an adhesive printed in the same way as the balls prior to the balls. The mask layer 2 forms an inverse pattern of the structure to be deposited. The structure may be any structure, e.g. a line- and/or grid-like structure, a structure having covered areas and non-covered areas. The structure may improve the current distribution in an organic electronic device or simply electrically connects the different units of an OLED device. The coated areas provide lines of increased current flow rates.

In a third process step (Fig. 1c) a second semiconductor, metal, and/or TCO (Transparent Conductive Oxide; e.g. ITO - Indium Tin Oxide) layer 4 is deposited on top of the mask layer 2 and on top of the first layer 3 where the first layer is not protected by the masking material 2. The second material is deposited e.g. by an evaporation or sputtering method in a vacuum atmosphere. The second layer 4 may be of the same material or a material different from the first layer 3. Instead of a single second layer 4, a layer system 4 of two or a plurality of layers comprising one or a plurality of semiconductor layers, metal layers, and/or TCO (Transparent Conductive Oxide) layers may be deposited in the step illustrated in Fig. 1c.

Afterwards, in a process step indicated in Fig. 1d the masking material 2 is removed from the first layer 3. A second patterned semiconductor, metal, or TCO (Transparent Conductive Oxide, e.g. ITO - Indium Tin Oxide) layer structure 4 is left on top of the first layer 3 in the areas that had not been covered by the masking material. The result is a patterned/structured semiconductor, metal, or TCO (Transparent Conductive Oxide) layer 4.

Another embodiment of the invention is illustrated in Figs. 2a to 2c.

In a first step a substrate 1 is provided, and a layer of a masking material 2 is deposited directly on the surface of the substrate 1. The masking material 3 is deposited by using an inkjet printing method. The masking material layer 2 is patterned to form a structure on the surface of the substrate 1 which is inverse to the line- and/or grid-like structure of an electrode of an organic electronic device to be formed.

Afterwards, in a subsequent process step illustrated in Fig. 2b the first layer 3 is deposited on top of the masking material layer 2 and, where the surface of the substrate 1 is not protected by the masking material, directly on the surface of the substrate 1. Instead of a single first layer 3, a layer system 3 of two or a plurality of layers comprising one or a plurality of semiconductor layers, metal layers, and/or TCO (Transparent Conductive Oxide) layers may be deposited in the step illustrated in Fig. 2b.

Afterwards, the masking material 2 and the metal material 3 deposited on top of the masking material 2 are removed from the substrate 1. Thereby, a patterned semiconductor, metal, or TCO (Transparent Conductive Oxide) layer 3 (line- or grid-like) is left directly on the surface of the substrate 1 forming a first electrode of an organic electronic device.

In this way the number of process steps may be reduced. Furthermore, it is not necessary to use a shadow mask for providing a patterned electrode layer on a substrate.

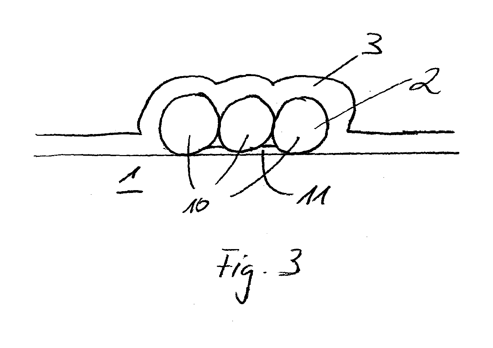

Figure 3 shows a sectional view of a coated substrate 1 according to the process step shown in figure 2d). Figure 3 shows a substrate 1 on which a patterned mask layer 2 and a deposited metal layer embodied as electrode layer 3 are present. Figure 3 shows only a part of the patterned mask layer 2. In the sectional view of figure 3 the part of the patterned mask layer 2 is formed by three balls 10 laying adjacent to each other. These balls 10 are fixed to the surface of the substrate 1 by an adhesive 11 which was deposited onto the surface of substrate 1 prior to the balls 10 of the masking material 2. The adhesive 11 may be deposited by inkjet printing similar to the inkjet printing of the balls 10. Alternatively, the adhesive 11 may be deposited together with the balls of the masking material by applying a mixture of adhesive and balls. In this case, the adhesive 11 will not only be present at the interface between the substrate 1 and the masking balls 10, but also around the surface of the balls 10 (not shown).

Figure 3 also shows the coating layer 3 which has been deposited by a vacuum deposition method, like sputtering, PVD (Plasma Vapour Deposition), especially evaporation technologies, chemical vapour deposition CVD or plasma enhanced chemical vapour deposition PECVD. The material of the coating layer 3 may be a metal, a transparent conductive oxide or the like to form an electrode layer.

The adhesive 11 may comprise an epoxy. The balls 10 of the masking material may be made of metal, plastic, polymer and combinations thereof. The masking balls 10 may be deposited by ink jetting or other suitable printing methods. Instead of balls, blocks or posts or the like may also be used. Balls, blocks or posts may have diameters in the range of a few nm up to some tenth of nm or some hundreds of nm and moreover up to some µm. Even diameters of 0.5 mm to 1.5 mm are considerable. Although the balls 10 are shown to be touching each other, it is understandable that space may exist between the adjacent balls 10.

After the deposition of the coating layer 3 the balls 10 may be removed together with the adhesive 11 by blasting the surface of the substrate 1 with an inert gas at high pressure. As an example nitrogen may be used as the inert gas. Moreover, carbon dioxide may also be used to remove the adhesive 11 and the balls 10.

In another embodiment the adhesive 11 and the masking material comprising the balls 10 may be removed by brushing.

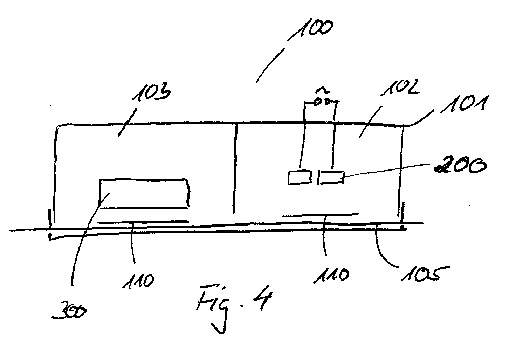

Figure 4 is a schematic illustration of a coating installation according to the present invention. The coating installation 100 comprises a vacuum chamber 101 divided into two sub chambers 103 and 102. In the sub chamber 103 deposition of the patterned mask is carried out, while in the sub chamber 102 deposition of the coating, for example deposition of a metal layer to form an electrode, is provided for. As can be seen from figure 4, a transport path 105 is provided for to transport the substrates 110 within the vacuum chamber 101 as well as into the vacuum chamber and out of the vacuum chamber. For this purpose lock means (not specified) are provided at the inlet and outlet.

In the vacuum sub chamber 103 the printing device 300 is located, like an inkjet printer for producing the patterned mask layer as shown in figures 1 and 2.

After the depositing of the patterned mask layer in the vacuum sub chamber 103 the substrate 110 is carried along the transport path 105 to the vacuum sub chamber 102 where the deposition of the electrode layer by a sputter process is performed. For this reason a twin magnetron electrode arrangement 200 is provided for sputtering a metal target. However, other materials may be deposited by other deposition technologies.

Although, printing of the patterned mask layer is shown to be performed in a vacuum chamber, the deposition of the patterned mask layer can also be performed in atmospheric environment. However, vacuum conditions may be advantageous with respect to oxidation and moisture problems which may arise with respect to the subsequent coating.

Although an installation for separate substrates, like large area glass substrates, silicon substrates or the like which are processed in a continuous way, are shown in figure 4, the invention is not restricted to processing of separate substrates, like glass or silicon substrates.

Instead of this, it is also possible to carry out the present invention for continuous, flexible substrates, like webs or foils or the like.

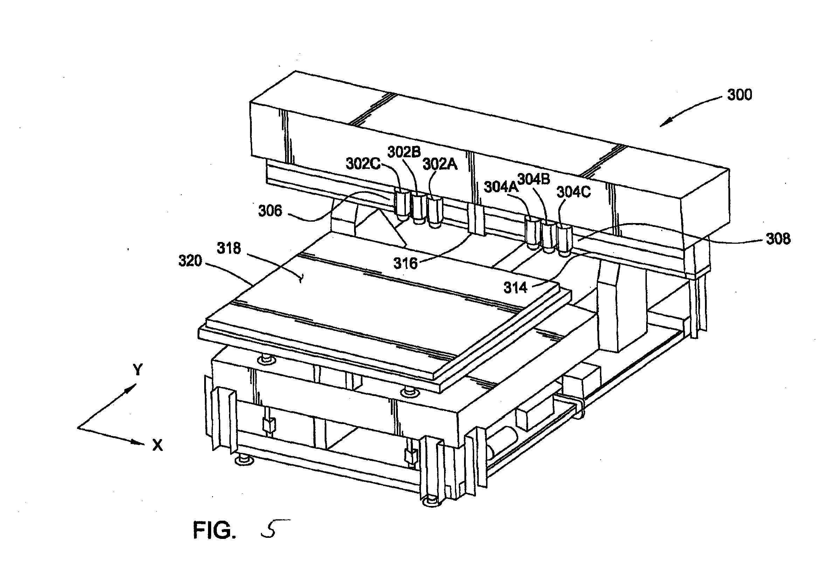

Figure 5 is a schematic perspective view of an apparatus 300 for inkjet printing according to an embodiment of the invention that may be used for printing a patterned mask and / or the adhesive. It is to be understood that while inkjet heads 306, 308 have been shown, more or less inkjet heads may be present. Each inkjet head 306, 308 may have one or more nozzles 302A - 302C, 304A-304C for dispensing the balls and / or adhesive on to the substrate. The apparatus 300 also includes a bridge 314 on which the inkjet heads 306, 308 are mounted. The inkjet heads 306, 308 may be spaced apart along the bridge 314 in an array fashion such that multiple inkjet heads 306, 308 may be used to deliver adhesive and / or masking balls to the substrate 318. In one embodiment the inkjet heads 306, 308 deliver masking material to different areas of the substrate 318. In another embodiment the inkjet heads 306, 308 may be coupled together. One or more monitors or cameras 316 may be mounted to the bridge 314. A substrate 318 may be disposed on a substrate stage 320. During the operation, the substrate stage 320 may move the substrate 318 under the inkjet heads 306, 308, where masking material may be dispensed onto the substrate 318. The monitors or cameras 316 may perform metrology on the masking material as well as on the deposited material.

Although the present invention has been described with respect to specific embodiments, it is evident for a man skilled in the art, that the invention is not restricted to these embodiments, but that modifications and alterations are possible, for example omitting one or more of the features described or combining the features in a different way, without leaving the scope of the attached claims. The present invention especially comprises all combinations of the single features described herein.

## Claims

1. A method of coating a substrate (1), comprising the steps of:
providing a substrate (1) having at least one surface to be coated;
depositing a patterned mask layer (2) on the at least one surface of the substrate (1) by using a printing method, the patterned mask layer comprising one or more balls; depositing at least one layer (3,4) of coating material on the surface of the substrate (1) having the patterned mask layer (2) deposited thereon, depositing of the at least one layer being performed by at least one of the group comprising a vacuum deposition method, a sputtering method, an evaporation method, a plasma coating method, a CVD method, and a PVD method.

2. The method of coating a substrate according to claim 1,
wherein
the step of depositing at least one layer of coating material (3,4) on the surface of the substrate (1) comprises depositing at least one material of the group comprising carbon, amorphous carbon, silicon nitride, a semiconductor material, a metal material, and a TCO (Transparent Conductive Oxide) material.

3. The method of coating a substrate (1) according to any of the previous claims,
wherein
the method is carried out for providing at least one out of the group comprising a patterned electrode, a current enhancement structure and a water barrier layer of an organic electronic device on the substrate (1).

4. The method of coating a substrate (1) according to any of the previous claims,
wherein
the method step of providing a substrate comprises a step of depositing at least one layer on the substrate (1) prior to depositing a patterned mask layer.

5. The method of coating a substrate (1) according to any of the previous claims,
wherein
the method comprises a step of providing an optoelectronic device layer for the emission of light on the substrate.

6. The method of coating a substrate (1) according to any of the previous claims,
wherein
the step of depositing a patterned mask layer comprises at least one of the printing methods of the group comprising inkjet printing, screen printing, porous printing, pad printing and a combination of such printing methods.

7. The method of coating a substrate (1) according to any of the previous claims,
wherein
the one or more balls comprise a plurality of balls, and wherein adjacent balls contact each other.

8. The method of coating a substrate (1) according to any of the previous claims,
wherein
the step of depositing a patterned mask layer comprises the step of depositing an adhesive in the area of the patterned mask layer prior to depositing the patterned mask layer.

9. The method of coating a substrate (1) according to claim 8,
wherein
the step of depositing an adhesive comprises at least one of the printing methods of the group comprising inkjet printing, screen printing, porous printing, pad printing anda combination of such printing methods.

10. The method of coating a substrate (1) according to any of the previous claims,
wherein
the step of depositing a patterned mask layer comprises the step of depositing a mixture of an adhesive and one or more balls.

11. The method of coating a substrate (1) according to any of the previous claims,
wherein
the balls are nanoparticles or microparticles.

12. The method of coating a substrate (1) according to any of the previous claims,
wherein the method includes a further process step of removing the mask material (2) from the substrate (1).

13. The method of coating a substrate (1) according to claim 12,
wherein
the step of removing the mask material comprises a process selected from the group consisting of brushing, wiping, cleaning, gas blasting and combinations thereof.

14. The method of coating a substrate (1) according to any of the previous claims,
wherein
the steps of depositing a patterned mask layer and of depositing at least one layer of coating material are carried out repeatedly.

15. The method of coating a substrate (1) according to any of the previous claims,
wherein
the one or more layers deposited on the surface of the substrate (1) having the patterned mask layer (2) deposited thereon extend under at least a portion of the patterned mask layer.

16. A coating installation comprising:
a printing tool (300) for printing a patterned mask (2) on a surface of a substrate, the printing tool being adapted to print a mask material comprising balls;
a supply device for supplying mask material comprising balls; and
a process chamber for arranging the substrate (1) having the patterned mask deposited on the surface thereof in the process chamber; the process chamber comprising coating tools for depositing a coating layer (3,4) on the surface of the substrate (1) having a patterned mask thereon wherein the coating tools are adapted to perform at least one of the coating methods of the group comprising a vacuum deposition method, a sputtering method, an evaporation method, a plasma coating method, a CVD method, and/or a PVD method.

17. The coating installation according to claim 16,
wherein
the process chamber comprising at least one of a coating material source selected from the group comprising a carbon source, a silicon source, a nitrogen source, a silicon nitride source, a metal material source, a semiconductor material source, and a TCO (Transparent Conductive Oxide) material source.

18. The coating installation according to any of the previous claims 16 to 17,
wherein
the printing tool for printing the patterned mask (2) includes an inkjet printer, a screen printer, and/or a pad printing equipment.

19. The coating installation according to any of the previous claims 16 to 18,
wherein
the coating equipment includes a further coating station comprising coating tools for depositing an organic electronic device on the substrate (1).

20. The coating installation according to any of the previous claims 16 to 19,
wherein
the coating equipment further comprises tools for removing the patterned mask material (2) from the surface of the substrate (1).
